# EUROPEAN PATENT SPECIFICATION

(11) **EP 2 817 430 B1**
(45) Date of publication and mention of the grant of the patent: **19.12.2018**
(21) Application number: 13711932.7
(22) Date of filing: 25.02.2013
(51) Int. Cl.: C23C 14/06, C23C 14/02, C23C 14/35, C23C 28/00, H01M 8/0206, H01M 8/0213, H01M 8/0215, H01M 8/0228, H01M 4/88, H01M 8/021

(54) **COATING WITH CONDUCTIVE AND CORROSION RESISTANCE CHARACTERISTICS**
LEITFÄHIGE UND KORROSIONSBESTÄNDIGE BESCHICHTUNG
REVÊTEMENT PRÉSENTANT DES CARACTÉRISTIQUES DE CONDUCTION ET DE RÉSISTANCE À LA CORROSION

(30) Priority: 24.02.2012 GB 201203219
(43) Date of publication of application: 31.12.2014
(73) Proprietor: Teer Coatings Limited, Droitwich WR9 9AS (GB)
(72) Inventor: COOKE, Kevin, Droitwich West Midlands WR9 9AS (GB); EITZINGER, Gunter, A-4655 Vorchdorf (AT); FIELD, Susan, Droitwich West Midlands WR9 9AS (GB); SUN, Hailin, Droitwich West Midlands WR9 9AS (GB)
(74) Representative: Wood, Graham
(86) International application number: PCT/GB2013/050465
(87) International publication number: WO 2013/124690

(56) References cited:
- EP-A1- 1 231 655
- WO-A1-2008/007095
- GB-A- 2 331 998
- US-A1- 2007 141 439
- US-A1- 2008 160 390
- US-A1- 2010 285 396

## Description

The invention to which this application relates is a coating for application to at least one surface of an article to provide that surface with certain required characteristics. Particularly, but not necessarily exclusively, the said article is a plate for use in a fuel cell that converts the chemical energy from a fuel into electricity through a chemical reaction with oxygen or another oxidizing agent. Hydrogen is the most common fuel, but hydrocarbons such as natural gas and alcohols like methanol are sometimes used for the provision of mainly electrical power. The present invention also provides a method for applying said coating.

It should be noted that although the invention is now described with reference to the use of the coating on fuel cell plates, the coating can be of use in other devices such as, for example, electrolysers, battery electrodes, electrodes for electroplating devices and, in general for use on the surfaces of devices which are to be used in a corrosive medium.

Fuel cells include bipolar plates which are conductive plates that are stacked together, with, typically a plate acting as an anode for one cell and a cathode for the next cell. The plates have a number of functions within the fuel cell stack which include separating the gasses between cells, providing a conductive medium, providing a flow field channel for the reaction gases and transferring heat out of the cell. The plates are required to be impermeable to gases, have good electrical conductivity, be resistant to corrosion and be relatively easy to manufacture in large quantities.

Conventionally there is a need for articles of this type to provide good conductivity while, at the same time, the condition of the articles needs to be maintained for at least a predetermined period of time in order for the life of the devices with which the articles are provided to be of an acceptable duration for commercial purposes. When one considers that the articles are often used in and exposed to highly corrosive medium which can adversely affect the condition and hence performance of the articles to a significant extent and over a relatively short period of time it will be appreciated that there is a well known need to address this problem.

Conventionally the problem has been addressed in different ways, one is to have a plate formed of a material which is able to fulfil this, like gold, palladium, or carbon on its own which has some disadvantages regarding costs, space, mechanical properties, or by the provision of a coating on the external surface of a material which has some benefits regarding costs, stiffness, space, mechanical strength but not the surface conductivity, or at least the surface of the articles which is exposed to the corrosive medium, which surface is formed of a relatively expensive conductive metal, such as gold, which allows the conductivity of the article to be maintained whilst resisting the influence of the corrosive medium. While this form of coating can be effective the cost of the same means that the devices formed which include these articles can be prohibitively expensive and/ or the result is pressure to reduce the thickness of the coating to such an extent that the same can become ineffective. Despite these problems and cost, the use of these coatings has, until now, been the most common approach.

It is known to provide a conductive carbon coating on the surface of articles and US2008/160390 discloses such a coating. WO2008/007095 discloses apparatus for applying such a coating and this document, and GB2331998, disclose coatings in which the layer of the carbon material is primarily of the sp2 form. E P1231655 discloses a separator for a solid polymer electrolyte type fuel cell and at least part of the separator which is to make contact with a gas diffusion layer is coated with a coating layer including a conducting hard carbon film.

The aim of the present invention is to provide improvements to this form of coating in order to provide a coating which has beneficial effects in terms of both the electrical conductivity and other characteristics which allow the commercial implementation of the same and also allow the articles to be resistant to the adverse effects of the corrosive medium. Not only does the coating ensure the continued operation of the component or plate by maintaining a high level of conductivity over time, but by reducing the electrical resistance inherent at the surface of the component or plate to a value below that of the uncoated material, it can improve the overall power density capability of the device for operation at a desired voltage or current.

In a first aspect of the invention there is provided an article, said article including a base or plate formed of an electrically conductive material and a coating applied thereto to cover at least part of the external surface of the same, said coating including, at at least it's external face, a conductive carbon material layer and intermediate said external face and the base there is provided at least one intermediate layer of one or more electrically conductive materials, and the carbon material of the carbon material layer is of a substantially graphitic sp2 form at least at and/or adjacent to, the external surface of the coating and characterised in that the coating is graded by grading the sp2/sp3 carbon bond ratio in the substantially carbon material layer such that the ratio of sp2 to sp3 increases towards the external surface of the coating.

In one embodiment the at least one intermediate layer is a layer of a nitride and/or carbide. In one embodiment the at least one layer of nitride and/ or carbide material is located in contact with the external surface of the base of the article. In one embodiment the coating, in addition or alternatively to the nitride and/or carbide includes a metal or metal alloy. In one embodiment the metal or metal alloy is any, or any combination, of Ti or NiCr.

In one embodiment a noble metal is included in the coating and the metal used is gold.

In one embodiment the noble metal layer is located such as to have the carbon material applied thereon to form the external face of the coating.

In one embodiment the transition between the intermediate layer adjacent the carbon layer, and the carbon layer of the coating is graded. In one embodiment there is provided a metal or metal alloy layer onto which the substantially carbon layer is applied. In one embodiment the metal or metal alloy layer and the carbon layer are compositionally and/ or structurally graded. The provision of this form of layers assists in achieving improved formability and stampability of the article during subsequent mechanical processing, and hence to retain the integrity and functionality of the coating. In one embodiment at least part of the coating is graded on the basis of density.

In addition or alternatively there is provided an identifiable interface between the nitride and carbon materials.

Typically the nitride and/ or carbide layer is used to provide any, or any combination of, adhesion for the coating to the base, a barrier layer for the base material and/ or corrosion protection for the base material, and enhanced mechanical durability, during manufacture and in service. The coating also provides improved stampability in that the coating can be more easily formed and shaped to suit specific purposes, such as being shaped to act as a coating for a fuel cell plate, whilst ensuring that the coating itself retains it's integrity in that there is a reduced risk of the coating cracking or failing during the forming and/ or stamping process.

In one embodiment the said coating is of high mechanical integrity.

In one embodiment the surface of the base onto which the coating is applied is pre-treated to provide a required surface topography to aid adhesion of the coating to the base and/or increase conductivity of the article and/or to influence the subsequent nucleation and growth of a superior layer or layers which may be applied

Thus there is provided in accordance with an embodiment of the invention a bipolar plate for a fuel cell coated with a chemically stable and electrically conductive coating of a metal nitride, a metal carbide or a metal carbo-nitride, onto which is applied a substantially carbon material layer formed of non-hydrogenated amorphous carbon layers having a selected sp2/sp3 ratio , and at least part of the coating is graded and the substantially carbon material is of a substantially graphitic sp2 form at least at and/or adjacent to the external surface of the coating and the coating is graded by grading the sp2/sp3 carbon bond ratio in the substantially carbon material layer such that the ratio of sp2 to sp3 increases towards the external surface of the coating.

In one embodiment the carbon coating is a chemically stable coating of substantially amorphous carbon with a surface layer providing a contact angle against water in the range 30 to 150° preferably 30° to 90° and yet further preferably in the range of 30° to 50°.

In one embodiment the plate is formed of a metal or metallic alloy.

In one embodiment the layer of the base onto which the coating is to be applied and/or any coating sub layer is doped with a metal atom.

In one embodiment the said compound is an electrically conductive nitride, carbide or carbo-nitride, most preferably a compound of a transition metal including, but not limited to, TiN, CrN, ZrN, TiC or TiCN. In one embodiment the said compound layer has an Interfacial Contact Resistance (ICR) of <25 m 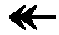 cmE and preferably < 15 m 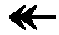 cmE and yet further preferably < 10 m 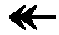 cmE

In one embodiment the non-hydrogenated amorphous carbon layers have an ICRof < 15 m 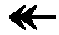 cmE.

Preferably the metal in the mixed carbon-metal layers is chromium, titanium, zirconium or niobium.

In one embodiment the mixed carbon-metal layers have a metallic content of 0.1 to 10 atomic %.

In one embodiment there is provided a plate or base at least partially coated with a chemically stable coating of amorphous carbon with a surface area exceeding more than 30, and up to 50 times that of the apparent or projected area and forms a high surface area (HSA) coating. The provision of the High Surface Area coating can be controlled so as to provide the coating with specific characteristics such as the control of the hydrophicility of the coating.

In addition or alternatively the surface of the coating can be roughened to improve the hydrophicility of the coating.

Typically the bipolar plate is fabricated from any or any combination of a low carbon steel, austenitic steel low alloy steel, aluminium or aluminium alloy, titanium or titanium alloy and coated with a corrosive resistant first metal layer.

Typically the bipolar plate is coated with an electrically conductive transition metal nitride, such as CrN, TiN or Z rN

In a yet further aspect of the invention there is provided a method for forming a coating on an article having a base or plate including a conductive metal wherein the method includes the step of applying a coating including at least one non-hydrogenated amorphous carbon layer by magnetron sputtering from at least one graphite target to form an external surface on at least part of the base or plate and, prior to applying the said non hydrogenated amorphous carbon layer, applying at least one intermediate layer of a conductive material between said base or plate and the said non-hydrogenated amorphous carbon layer, and the substantially carbon layer is of a substantially graphitic sp2 form at least at and/or adjacent to the external surface of the coating characterised by grading the sp2/sp3 carbon bond ratio in the non-hydrogenated amorphous carbon layer such that the ratio of sp2 to sp3 increases towards the external surface of the coating.

In one embodiment at least one non-hydrogenated amorphous carbon metal layer is prepared by means of sputter-deposition from composite carbon-metal targets of an appropriate composition.

In one embodiment a plurality of carbon-metal layers are prepared by sputter-deposition from graphite targets with metallic inserts.

In one embodiment the method includes the step of applying at least one carbon containing layer with a required wettability characteristic using any, or any combination of, electrochemical methods, physical vapour deposition and/or chemical vapour deposition.

In one embodiment the coating is applied to the articles which are mounted on a rotary holder within a vacuum chamber in which a number of magnetrons are located to allow material to be deposited from the magnetrons onto the articles to form the coating thereon.

In one embodiment the magnetrons are unbalanced and provided with respective magnet arrays incorporated therein or located adjacent thereto so as to create a substantially closed field configuration. In an alternative embodiment the coating is applied using a substantially linear coating application.

In a preferred embodiment the method includes the initial step of removing oxidation which may have occurred on the external face of the base or plate of the article. Oxidation is known to reduce the performance of the article so the substantial removal of the same is a beneficial step to the performance of the article.

In one embodiment the removal of the oxidation is achieved by the use of sputter cleaning and /or chemical etching.

In one embodiment, following the removal of oxidation the external face of the base or plate onto which the coating is to be applied is pre-treated so as to create a roughening effect on the same.

In one embodiment the method includes a final step of creating a high surface area external surface effect to the coating.

In one embodiment the external surface of the coating is provided with a hydrophobic or hydrophilic characteristic.

Specific embodiments of the invention are now described with reference to the accompanying drawings; wherein
Figure 1 illustrates a plan view of one embodiment of apparatus used to form the coating in accordance with one embodiment of the invention;
Figure 2 illustrates apparatus used to test the coating applied in accordance with one embodiment of the invention;
Figure 3 illustrates graphically the measured interfacial contact resistance of the coated SS316L with Toray H120 GDL;
Figure 4 illustrates a cross section of a TiN+C coating formed in accordance with one embodiment of the invention;
Figure 5 illustrates the relative intensity of the materials used during the coating process; and
Figures 6 and 7 show potentiodynamic electrochemical test results of coatings in accordance with the invention.

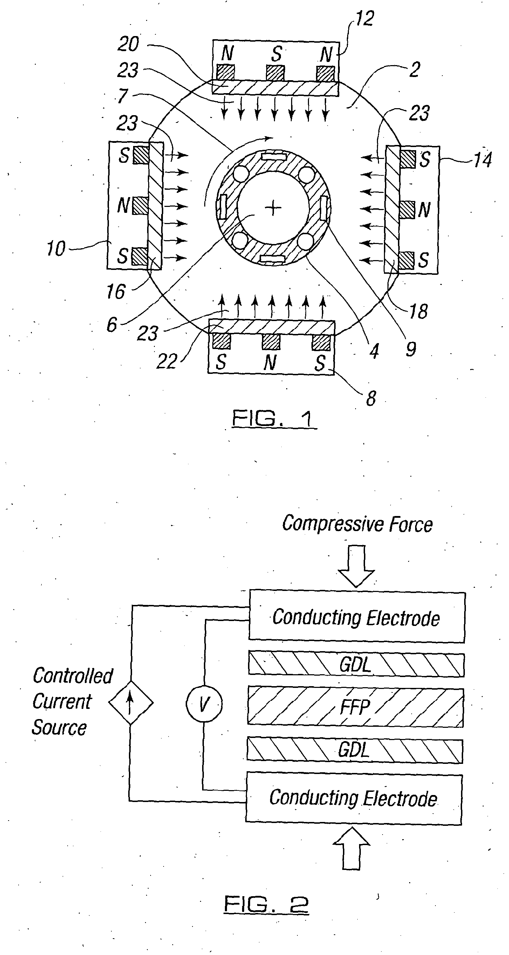

The apparatus used to apply the coatings in accordance with one embodiment of the invention is shown in Figure 1 and the same comprises a vacuum chamber 2 in which there is mounted a rotary carrier 4 provided to be rotatable about central axis 6 as indicated by arrow 7. The carrier has an external surface on which the articles to be coated, in this case bipolar plates 9, are mounted in order to have the coating applied thereto. The apparatus shown in Figure 1 also includes four magnetrons, 8,10,12,14 provided in a closed field configuration and the targets of the magnetrons comprise two carbon targets, 16,18 and two metal targets 20,22 with material selectively sputtered from the same towards the samples or plates 9 as indicated by arrows 23. It should be noted that while the illustration in Figure 1 includes 4 magnetron coating sources, other configurations may be used, including, but not limited to, 6 magnetrons around a similar cylindrical chamber wherein the components to be coated are rotated in front of the said coating sources, or directly opposed magnetrons where the substrate traverses in a linear fashion between them, i.e. a so-called "in line" configuration. It should also be appreciated that the sputter deposition system illustrated in Figure 1 may not be the only way by which to form the coating in accordance with the invention. An alternative apparatus could be High Power Impulse Magnetron sputtering (HiPIMS) apparatus.

In one embodiment the method used to form a coating on an article, in this case in the form of a fuel cell plate held on the carrier in the coating chamber, comprises the following steps.

In this example, the coatings were formed by magnetron sputter ion plating, specifically closed field unbalanced magnetron sputter ion plating (CFUBMSIP) using two or more magnetrons in a closed field.

Prior to the application of the coating, the Bipolar Plates were cleaned in a dedicated cleaning solvent with or without ultrasonic agitation and completely dried They were placed into the coating chamber which was then pumped down to a pressure of typically lower than 2.0 x 10⁻⁵ torr.

At the start of the coating process, Argon gas is admitted to the chamber to reach a pressure of typically between 8.0 x10⁻⁴ and 8.0 x10⁻³ torr depending on the coating required.

In one embodiment a carbon based coating is applied to the plate and the targets of the magnetrons comprise 2 chromium (Cr) targets and 2 graphite (C) targets but it should be noted that the number of targets can vary as can the ratio of C to Cr targets to suit specific requirements. During the application of the coating the samples are held at an average bias voltage value between -350V and -50V which varies depending on the specific process step, such negative substrate bias being generated preferably by a pulsed DC power supply.

The first step of the process is an ion cleaning step with a relatively low current of typically 0.45mAcm⁻² provided on each Cr target and 0.30mAcm⁻² typically on each Carbon or graphite target. The voltage can bin the region of 400 Volts.

Alternatively, another source of energetic gaseous ions or atoms, such as a so-called linear ion source, may be employed, either alone or in combination with the applied substrate bias, in order to effect the in situ pre-cleaning of the substrates.

A Cr adhesion layer is then deposited with, typically, a current of 6mAcm⁻² supplied to one or more Cr targets.

A graded interface between the Chromium material and the carbon material which is deposited is created by, over time, reducing the current supplied to the Cr target/s and increasing the current supplied to the carbon targets, typically from 0mAcm⁻² to 0.53mAcm⁻²

A layer of carbon, or carbon doped with <10 at % metal, is then deposited to form the external surface of the coating.

In another embodiment a TiN+C coating is applied and the apparatus, in this case, includes 2 titanium (Ti) targets and 2 graphite (C) targets which are used in the process. Once again the number of targets can be varied, as can the ratio of C to Ti targets. During the process the samples are held at an average bias voltage value between -400V and -50V which is varied depending on the process step. The first step of the process is an ion cleaning step with relatively low currents of 0.4 to 0.6mAcm⁻² applied on each Ti target.

Alternatively, another source of energetic gaseous ions or atoms, such as a so-called linear ion source, may be employed, either alone or in combination with the applied substrate bias, in order to effect the in situ pre-cleaning of the substrates.

A Ti adhesion layer is then deposited with a current of 6mAcm⁻² to 10.5mAcm⁻² supplied to each Ti target.

A TiN layer is then created by introducing N₂ to the coating chamber with the flow of the gas controlled by an OEM system in order to achieve and maintain a required level of stoichiometry in the deposited coating.

A TiN layer doped with carbon is deposited as an interfacial layer followed by a top or external surface layer of Carbon being deposited.

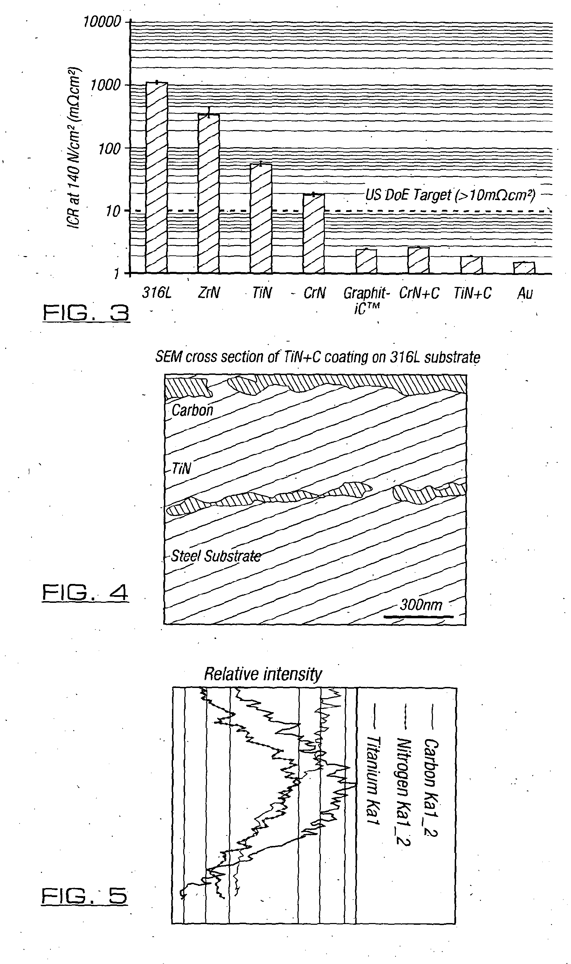

Figure 4 illustrates a cross section of a TiN+C coating formed in accordance with one embodiment of the invention and shows how the coating comprises multilayers including the TiN intermediate layer and the Carbon top layer which forms the external surface of the coating once applied to the base or plate in the form of the steel substrate. Figure 5 illustrates the relative intensities of the Carbon, Titanium and Nitrogen during the formation of the coating.

In one embodiment the Carbon layer may also be doped with metal. The magnetron configuration used to produce the coatings is that as shown in Figure 1.

Test results for coatings applied as described above are provided below.

The Interfacial Contact Resistance (ICR) values of the coating were determined using the set up arrangement shown in Figure 2. In this arrangement, the sample is placed between two Gas Diffusion Layers (GDL's) and the total resistance is measured at a 140 N cm⁻¹ after 300s of time. The resistance of the GDL alone is then also measured, after which, the value can be subtracted from the total resistance and divided by two to give the ICR of one surface. This arrangement method assumes that the bulk conductivity of the carbon GDL is negligible.

Figure 3 illustrates the ICR measurements which have been obtained for coatings in accordance with the invention in comparison to other known coatings. It is clear that the provision of the multilayer coating in accordance with the invention significantly improves the surface conductivity of the article with e carbon outer layer having the greatest impact on the conductivity which can be achieved.

In this work study the equipment used included a Zwick/Roell Z030 compression machine with a 50 kN load cell and a Thurlby Thandar BS407 micro ohm meter which utilised the four wire measurement method. Toray H120 GDLs, each of 1cm², were used and were conditioned before testing by compressing three times to 140 N cm⁻¹.

Both of the coatings which were tested also showed improved corrosion performance over the uncoated plate or base of stainless steel at high potentials. It also believed that the substantial removal of the existing surface oxidation and the provision of the nitride or carbide layer at the base or plate improves the electrical surface area conductivity of the plate.

In whichever embodiment the coating which is applied can be applied in two processes, a first process to apply the coating up to and including the at least one intermediate layer and a second process to apply a metal layer followed by the carbon containing layer or layers onto the intermediate layer.

In one embodiment the said processes may be performed on two separate items of apparatus. By depositing a relatively thin metallic interlayer such as Cr or Ti on top of the previously deposited intermediate layer such as a nitride or carbide before introducing the carbon containing layer or layers so the adhesion between the intermediate layer and the carbon containing layer is improved.

The present invention therefore provides a coating, an article which is coated with the same and a device incorporating the articles so formed which has advantages over the prior art in terms, of reduced cost, high durability, higher conductivity into the surface of the base or plate of the article, relatively high ability to be formed subsequent to the application of the coating and/or relatively high rates of deposition of the coating and hence throughput of the articles.

In a further embodiment of the invention there are provided further advantages to the coating in which Bipolar plates are coated with TiN in which further layers of Chromium plus carbon doped with chromium (<10 at%) or metal doped amorphous carbon coating are used.

In this example electrochemical testing for corrosion resistance is performed as corrosion resistance is an important factor in gauging the likely practical performance of bipolar plate materials. Potentiodynamic experiments were carried out using an Autolab PGSTAT302N potentiostat connected to a computer. The electrochemical cell was a Bio-logic 250 ml jacketed flat corrosion cell with a 1 cm² sample area linked to a thermostatically controlled bath with a 1 cm² sample area. The cell was placed in a Faraday cage to reduce electrical interference from surrounding equipment. A C10-P5 Thermo Scientific circulating water bath was used to maintain the temperature of the cell at 70 °C.

A three electrode setup was used where the working electrode was an as-received AISI316L 0.1 mm foil which had been coated by the PVD equipment described above, and was cleaned with acetone and dried prior to immersion. A Mercury/Mercury Sulphate Electrode (MSE) was used as the reference electrode rather than a Saturated Calomel Electrode (SCE) to avoid any possible chlorine contamination. A platinum mesh was used as the counter electrode and had a considerably greater geometric surface area than that of the working electrode. The electrolyte used was 250 ml of 0.5M H₂SO₄.

The procedure involved bubbling the electrolyte with either air or hydrogen for 20 mins after which the delivery tube was withdrawn from the solution but left within the electrochemical cell to maintain the chosen atmosphere. The Open Circuit Potential (OCP) was then recorded for 40 mins. Following this, a potentiodynamic scan was then initiated recorded from 250 mV below the OCP value at a scan rate of 1 mVs⁻¹ until the measured current density reached ∼10⁻² Acm⁻¹.

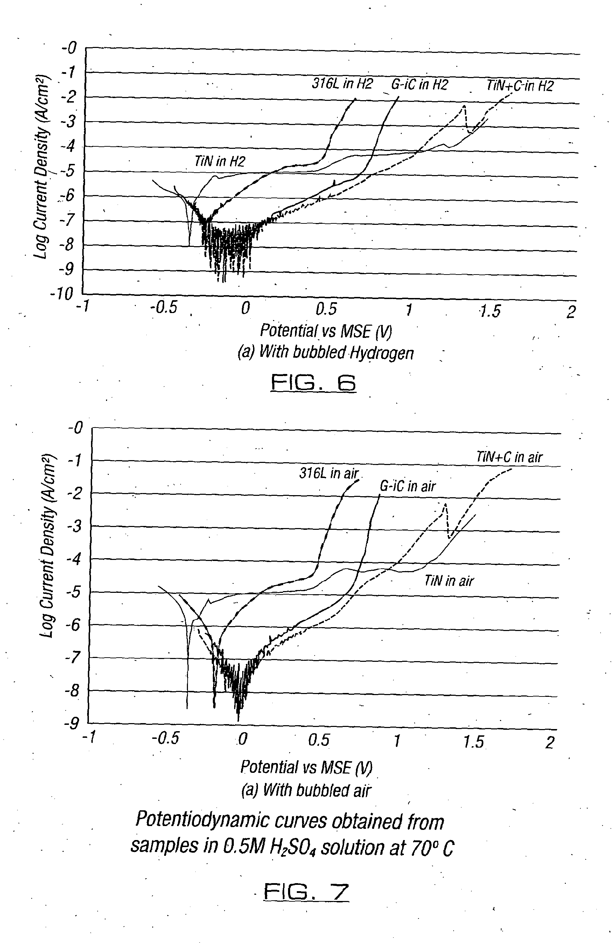

The free corrosion potential (Ecorr) of TiN coating was less noble than the as-received stainless steel which was attributed to its natural affinity to oxidise. However, at higher potentials this presumed TiOx layer provided protection to the AISI316L foil. The Metal doped amorphous carbon coating chromium plus carbon doped with chromium coatings (labelled G-iC in the Figures 4 and 5 offer much more noble Ecorr values for the anode and cathode compared to AISI 316L. TiN+C coatings offer both noble Ecorr values and lower current densities at higher potentials when tested with bubbled air as shown in Figure 6 and bubbled hydrogen as shown in Figure 7 to simulate PEMFC, cathode and anode environments respectively.

The coatings of the invention may also be applied using so-called reel to reel or coil to coil coating apparatus in order to provide a coating for a continous or segmented strip. This allows articles which have an optimised coating to be formed afterward and separated from the coated strip in subsequent processes. The adhesion and the mechanical characteristics of the coatings are advantageous to the retention of the desired properties, including electrical conductivity and corrosion resistance, of the surface of the formed articles. The coating may also confer advantages to the said forming process.

The coating is of particular benefit for use in articles such as catalysts for electrolysers, and plates for fuel cells. It is found that significant costs savings can be achieved by for example, reducing the thickness of the coatings which are required to be applied whilst at least maintaining the performance levels such as by applying coatings of 0.4 µm compared to conventional coatings of 2 µm in thickness. It is also possible to reduce the manufacturing time of the finished, coated, article by increasing the deposition rates of the material used to form the coatings.

## Claims

1. An article (9), said article including a base or plate formed of an electrically conductive material and a coating applied thereto to cover at least part of the external surface of the same, said coating including, at at least it's external face, a conductive carbon material layer and intermediate said external face and the base there is provided at least one intermediate layer of one or more electrically conductive materials, and the carbon material of the carbon material layer is of a substantially graphitic sp2 form at least at and/ or adjacent to, the external surface of the coating and **characterised in that** the coating is graded by grading the sp2/sp3 carbon bond ratio in the substantially carbon material layer such that the ratio of sp2 to sp3 increases towards the external surface of the coating.

2. An article according to claim 1 wherein the at least one intermediate layer is formed of nitride and/or carbide material.

3. An article according to claim 2 wherein the nitride and/or carbide layer provides any, or any combination of, adhesion for the coating to the base, a barrier layer for the base material and/ or corrosion protection for the base material.

4. An article according to claim 1 wherein the coating includes a metal or metal alloy layer and/ or a metal oxide layer.

5. An article according to claim 1 wherein the transition between the substantially carbon material layer and at least one intermediate layer is graded.

6. An article according to claim 1 wherein the coating is graded on the basis of density.

7. An article according to claim 1 wherein, when provided, the noble metal layer is located such as to have the carbon material applied thereon to form the external face of the coating.

8. An article according to claim 1 wherein the base or plate is a bipolar plate for use as part of a fuel cell.

9. An article according to claim 1 wherein the layer of the base onto which the coating is to be applied and/or any coating sub layer is doped with a metal atom.

10. An article according to claim 1 wherein the at least one intermediate layer is an electrically conductive nitride, carbide or carbo-nitride and/ or a compound of a transition metal.

11. An article according to claim 1 wherein the said at least one intermediate layer has an Interfacial Contact Resistance (ICR) of < 25 m 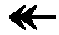 cmE and preferably < 15 m 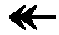 cmE and the at least one carbon layer has an ICR of < 15 m 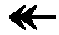 cmE

12. An article according to claim 1 wherein the mixed carbon-metal layers have a metallic content of 0.1 to 10 atomic %.

13. An article according to claim 1 wherein the surface of the coating has a contact angle against water in the range 30 to 150°.

14. An article according to claim 1 wherein the external surface of the coating has a surface area exceeding more than 30 times that of the apparent or projected area of the coating.

15. An article according to claim 1 wherein there is provided a metallic interlayer on top of the said at least one intermediate layer.

16. A method for forming a coating on an article (9) having a base or plate including a conductive metal wherein the method includes the step of applying a coating including at least one non-hydrogenated amorphous carbon layer by magnetron sputtering from at least one graphite target (16,18) to form an external surface on at least part of the base or plate and, prior to applying the said non hydrogenated amorphous carbon layer, applying at least one intermediate layer of a conductive material between said base or plate and the said non-hydrogenated amorphous carbon layer, and the substantially carbon layer is of a substantially graphitic sp2 form at least at and/ or adjacent to the external surface of the coating **characterised by** grading the sp2/sp3 carbon bond ratio in the non-hydrogenated amorphous carbon layer such that the ratio of sp2 to sp3 increases towards the external surface of the coating.

17. A method according to claim 16 wherein the surface of the base or plate onto which the coating is to be applied is pre-treated to provide a surface topography to aid adhesion of the coating to the base or plate and/or increase conductivity of the article and/or to influence the subsequent nucleation and growth of a subsequent layer or layers which may be applied

18. A method according to claim 16 wherein at least one non-hydrogenated amorphous carbon metal layer is applied by sputter-deposition from composite carbon-metal targets of an appropriate composition.

19. A method according to claim 16 wherein a plurality of carbon-metal layers are prepared by sputter-deposition from graphite targets with metallic inserts.

20. A method according to claim 16 wherein the method includes the initial step of removing oxidation from the external face of the base or plate of the article by sputter cleaning and/or chemical etching.

21. A method according to claim 20 wherein following the removal of oxidation the external face of the base or plate onto which the coating is to be applied is pre-treated so as to create a roughening effect on the same.

22. A method according to claim 16 wherein the coating up to and including the intermediate layer is applied using a first material application process and some or all of the remainder of the coating is applied using a second material application process.

23. A method according to claim 16 wherein a metallic layer is applied on top of the previously deposited at least one intermediate layer before applying a carbon containing layer.

## Patentansprüche

1. Artikel (9), wobei der genannte Artikel eine Basis oder Platte aufweist, gebildet aus einem elektrisch leitfähigen Material und einer darauf aufgebrachten Beschichtung, um wenigstens einen Teil der Außenfläche derselben zu bedecken, wobei die genannte Beschichtung, wenigstens auf ihrer Außenfläche, eine leitfähige Kohlenstoffmaterialschicht aufweist und zwischen der genannten Außenfläche und der Basis wenigstens eine intermediäre Schicht aus einem oder mehreren elektrisch leitfähigen Materialien vorgesehen ist, und das Kohlenstoffmaterial der Kohlenstoffmaterialschicht eine im Wesentlichen graphitische sp2-Form wenigstens an und/oder neben der Außenfläche der Beschichtung hat, und **dadurch gekennzeichnet, dass** die Beschichtung durch Abstufen des sp2/sp3-Kohlenstoffbindungsverhältnisses in der im Wesentlichen Kohlenstoffmaterialschicht abgestuft ist, so dass das Verhältnis von sp2 zu sp3 in Richtung der Außenfläche der Beschichtung zunimmt.

2. Artikel nach Anspruch 1, wobei die wenigstens eine intermediäre Schicht aus Nitrid- und/oder Carbidmaterial gebildet ist.

3. Artikel nach Anspruch 2, wobei die Nitrid- und/oder Carbidschicht eine beliebige, oder eine beliebige Kombination von, Haftung für die Beschichtung an der Basis, einer Barrierenschicht für das Basismaterial und/oder Korrosionsschutz für das Basismaterial bereitstellt.

4. Artikel nach Anspruch 1, wobei die Beschichtung eine Metall- oder Metalllegierungsschicht und/oder eine Metalloxidschicht beinhaltet.

5. Artikel nach Anspruch 1, wobei der Übergang zwischen der im Wesentlichen Kohlenstoffmaterialschicht und wenigstens einer intermediären Schicht abgestuft ist.

6. Artikel nach Anspruch 1, wobei die Beschichtung auf der Basis von Dichte abgestuft ist.

7. Artikel nach Anspruch 1, wobei, falls vorhanden, die Edelmetallschicht so positioniert ist, dass das Kohlenstoffmaterial darauf aufgebracht ist, um die Außenfläche der Beschichtung zu bilden.

8. Artikel nach Anspruch 1, wobei die Basis oder Platte eine bipolare Platte zur Verwendung als Teil einer Brennstoffzelle ist.

9. Artikel nach Anspruch 1, wobei die Schicht der Basis, auf die die Beschichtung aufgebracht wird, und/oder eine beliebige Beschichtungssubschicht, mit einem Metallatom dotiert ist.

10. Artikel nach Anspruch 1, wobei die wenigstens eine intermediäre Schicht ein elektrisch leitfähiges Nitrid, Carbid oder Carbonitrid und/oder eine Verbindung aus einem Übergangsmaterial ist.

11. Artikel nach Anspruch 1, wobei die genannte wenigstens eine intermediäre Schicht eine Interfacial Contact Resistance (ICR) von < 25 m«-cE und vorzugsweise < 15 m«-cmE hat und die wenigstens eine Kohlenstoffschicht eine ICR von < 15 m«-cmE hat.

12. Artikel nach Anspruch 1, wobei die gemischten Kohlenstoff-Metall-Schichten einen Metallgehalt von 0,1 bis 10 Atom-% haben.

13. Artikel nach Anspruch 1, wobei die Oberfläche der Beschichtung einen Kontaktwinkel zu Wasser im Bereich von 30 bis 150° hat.

14. Artikel nach Anspruch 1, wobei die Außenfläche der Beschichtung einen Oberflächenbereich von mehr als dem 30fachen von dem der scheinbaren oder projizierten Fläche der Beschichtung hat.

15. Artikel nach Anspruch 1, wobei eine metallische Zwischenschicht auf der genannten wenigstens einen intermediären Schicht vorgesehen ist.

16. Verfahren zum Bilden einer Beschichtung auf einem Artikel (9) mit einer Basis oder Platte mit einem leitfähigen Metall, wobei das Verfahren die folgenden Schritte beinhaltet: Aufbringen einer Beschichtung mit wenigstens einer nichthydrierten amorphen Kohlenstoffschicht durch Magnetron-Sputtern von wenigstens einem Graphit-Target (16, 18) zum Bilden einer Außenfläche auf wenigstens einem Teil der Basis oder Platte und, vor dem Auftragen der genannten nichthydrierten amorphen Kohlenstoffschicht, Aufbringen von wenigstens einer intermediären Schicht aus einem leitfähigen Material zwischen der genannten Basis oder Platte und der genannten nichthydrierten amorphen Kohlenstoffschicht, wobei die im Wesentlichen Kohlenstoffschicht eine im Wesentlichen graphitische sp2-Form wenigstens an und/oder neben der Außenfläche der Beschichtung hat, **gekennzeichnet durch** Abstufen des sp2/sp3-Kohlenstoffbindungsverhältnisses in der nichthydrierten amorphen Kohlenstoffschicht, so dass das Verhältnis von sp2 bis sp3 in Richtung der Außenfläche der Beschichtung zunimmt.

17. Verfahren nach Anspruch 16, wobei die Oberfläche der Basis oder Platte, auf die die Beschichtung aufgebracht werden soll, vorbehandelt wird, um eine Oberflächentopografie zum Unterstützen der Haftung der Beschichtung an der Basis oder Platte und/oder zum Erhöhen der Leitfähigkeit des Artikels und/oder zum Beeinflussen der nachfolgenden Keimbildung und des Wachstums von einer oder mehreren evtl. aufgebrachten nachfolgenden Schichten bereitzustellen.

18. Verfahren nach Anspruch 16, wobei wenigstens eine nichthydrierte amorphe Kohlenstoff-Metall-Schicht durch Aufsputtern von Composite-Kohlenstoff-Metall-Targets einer geeigneten Zusammensetzung aufgebracht wird.

19. Verfahren nach Anspruch 16, wobei mehrere Kohlenstoff-Metall-Schichten durch Aufsputtern von Graphit-Targets mit metallischen Einsätzen hergestellt werden.

20. Verfahren nach Anspruch 16, wobei das Verfahren den Anfangsschritt des Entfernens von Oxidation von der Außenfläche der Basis oder Platte des Artikels durch Sputter-Reinigen und/oder chemisches Ätzen beinhaltet.

21. Verfahren nach Anspruch 20, wobei nach dem Entfernen von Oxidation die Außenfläche der Basis oder Platte, auf die die Beschichtung aufgebracht werden soll, vorbehandelt wird, um einen Aufrauungseffekt darauf zu erzielen.

22. Verfahren nach Anspruch 16, wobei die Beschichtung bis zu und einschließlich der intermediären Schicht mit einem ersten Materialauftragsprozess aufgebracht wird und der Rest der Beschichtung ganz oder teilweise mit einem zweiten Materialauftragsprozess aufgebracht wird.

23. Verfahren nach Anspruch 16, wobei eine metallische Schicht auf die zuvor aufgebrachte wenigstens eine intermediäre Schicht aufgebracht wird, bevor eine kohlenstoffhaltige Schicht aufgebracht wird.

## Revendications

1. Article (9), ledit article présentant une base ou une plaque formée d'un matériau électriquement conducteur et d'un revêtement qui lui est appliqué pour couvrir au moins une partie de la surface externe de celle-ci, ledit revêtement consistant en au moins une face externe, une couche de matière carbonée conductrice et entre ladite face externe et la base est placée au moins une couche intermédiaire composée d'un ou de plusieurs matériaux électriquement conducteurs, et la matière carbonée de la couche de matière carbonée est de forme essentiellement graphitique sp2 au moins au niveau et/ou au voisinage de la surface externe du revêtement et est **caractérisée en ce que** le revêtement est classé par classification du rapport de liaison carbone sp2/sp3 dans la couche de matière essentiellement carbonée de sorte à ce que le rapport de sp2 à sp3 augmente en direction de la surface externe du revêtement.

2. Article selon la revendication 1 dans lequel au moins une couche intermédiaire est constituée de matériau de nitrure et/ou de matériau de carbure.

3. Article selon la revendication 2 dans lequel la couche de nitrure et/ou de carbure confère un quelconque ou une combinaison quelconque d'atouts parmi une adhésion du revêtement à la base, une couche barrière au matériau de base et/ou une protection contre la corrosion au matériau de base.

4. Article selon la revendication 1 dans lequel le revêtement contient une couche de métal ou d'alliage de métaux et/ou une couche d'oxyde métallique.

5. Article selon la revendication 1 dans lequel la transition entre la couche de matière essentiellement carbonée et au moins une couche intermédiaire est graduelle.

6. Article selon la revendication 1 dans lequel le revêtement est classé d'après la densité.

7. Article selon la revendication 1 dans lequel, si la couche de métal noble est fournie, elle est placée de sorte à ce que la matière carbonée appliquée sur celle-ci forme la face externe du revêtement.

8. Article selon la revendication 1, dans lequel la base ou la plaque est une plaque bipolaire pour utilisation en tant que partie d'une pile à combustible.

9. Article selon la revendication 1 dans lequel la couche de la base sur laquelle le revêtement et/ou toute sous-couche de revêtement est appelé(e) à être appliqué(e) est dopée d'un atome métallique.

10. Article selon la revendication 1 dans lequel la au moins une couche intermédiaire est un nitrure, un carbure ou un carbonitrure électriquement conducteur et/ou un composé d'un métal de transition.

11. Article selon la revendication 1 dans lequel ladite au moins une couche intermédiaire présente une résistance interfaciale de contact (ICR) inférieure à 25 m «-cmE et préférablement inférieure à 15 m «-cmE et la au moins une couche de carbone présente une ICR inférieure à 15 m «-cmE.

12. Article selon la revendication 1 dans lequel les couches de métal carboné ont une teneur en métal de 0,1 à 10 pourcent atomique.

13. Article selon la revendication 1 dans lequel la surface du revêtement a un angle de contact de 30 à 150 ° contre l'eau.

14. Article selon la revendication 1 dans lequel la surface externe du revêtement a une superficie dépassant plus de 30 fois celle de la zone apparente ou projetée du revêtement.

15. Article selon la revendication 1 dans lequel se trouve une couche intermédiaire métallique par-dessus ladite au moins une couche intermédiaire.

16. Procédé de formation d'un revêtement sur un article (9) présentant une base ou une plaque contenant un métal conducteur, le procédé comprenant l'étape d'application d'un revêtement contenant au moins une couche de carbone amorphe non hydrogéné par pulvérisation au magnétron à partir d'au moins une couche de graphite (16, 18) de manière à former une surface externe sur au moins une partie de la base ou de la plaque et, avant l'application de ladite couche de carbone amorphe non hydrogéné, d'application d'au moins une couche intermédiaire d'un matériau conducteur entre ladite base ou plaque et ladite couche de carbone amorphe non hydrogéné, et la couche essentiellement faite de carbone est d'une forme essentiellement graphitique sp2 au niveau et/ou au voisinage de la surface externe du revêtement **caractérisé par** le classement du rapport de liaison carbone sp2/sp3 dans la couche de carbone amorphe non hydrogéné de manière à ce que le rapport sp2 au sp3 augmente en direction de la surface externe du revêtement.

17. Procédé selon la revendication 16 dans lequel la surface de la base ou de la plaque sur laquelle le revêtement est appelé à être appliqué est prétraitée de manière à fournir une topographie de surface facilitant l'adhésion du revêtement à la base ou à la plaque et/ou augmentant la conductivité de l'article et/ou de manière à influencer la nucléation et la croissance ultérieures d'une ou de couches ultérieures susceptibles d'être appliquées.

18. Procédé selon la revendication 16 dans lequel une couche de métal carboné amorphe non hydrogéné est appliquée par dépôt par pulvérisation d'une composition appropriée à partir de cibles de métal carboné composite.

19. Procédé selon la revendication 16 dans lequel une pluralité de couches de métal carboné est préparée par dépôt par pulvérisation à partir de cibles de graphite avec des inserts métalliques.

20. Procédé selon la revendication 16, ledit procédé comprenant l'étape initiale d'élimination de l'oxydation de la face externe de la base ou de la plaque de l'article par nettoyage par pulvérisation et/ ou gravure chimique.

21. Procédé selon la revendication 20 dans lequel après le retrait de l'oxydation, la face externe de la base ou de la plaque sur laquelle le revêtement est appelé à être appliqué est prétraitée de manière à créer un effet de dégrossissage sur celle-ci.

22. Procédé selon la revendication 16 dans lequel le revêtement allant jusqu'à et incluant la couche intermédiaire est appliqué en utilisant un premier procédé d'application de matériau et une partie ou tout le restant du revêtement est appliqué en utilisant un deuxième processus d'application de matériau.

23. Procédé selon la revendication 16 dans lequel une couche métallique est appliquée par-dessus la au moins une couche intermédiaire préalablement déposée avant d'appliquer une couche contenant du carbone.
